# EUROPEAN PATENT APPLICATION

(11) **EP 4 621 833 A1**
(43) Date of publication of application: **24.09.2025**
(21) Application number: 24164978.9
(22) Date of filing: 20.03.2024
(51) Int. Cl.: H01L 21/67, H01L 21/687

(54) **IMPROVED POSITIONING DEVICE AND METHOD**

(71) Applicant: Leuven Air Bearings N.V., 3460 Bekkevoort (BE)
(72) Inventor: MELLAERTS, Arne, 3010 Kessel-Lo (BE); GORDTS, Gilles, 3140 Keerbergen (BE); DE MOERLOOZE, Kris, 9320 Nieuwerkerken (BE); SMETS, Kurt, 3510 Spalbeek (BE); SMITH, Rex, 3000 Leuven (BE); DOCKX, Sten, 1980 Zemst (BE); VAN DE VIJVER, Wim, 3560 Lummen (BE)
(74) Representative: IPLodge bv

(57) **Abstract**

The present invention concerns a positioning device (1) for inspection of wafers and chips, comprising a rotor (2) and a stator (3), the rotor comprising a rotor axis (A) defining a height direction, whereby the rotor (2) is engaged with the stator by a bearing (4) which is configured to allow rotational movement of the rotor (2) around the rotor axis and axial movement along the rotor axis, whereby the device (1) comprises a rotary (RT) actuator (5A, 5B) configured to induce a rotational movement on the rotor, whereby the rotary actuator (5A, 5B)) comprises a static actuator component (5A) attached to the stator, and a mobile actuator component (5B) attached to the rotor and configured to interact with the static actuator component to induce an rotational movement of the rotor with respect to the stator, whereby the device (1) comprises a linear height actuator (6A, 6B) provided along the rotor axis and configured to induce a linear movement on the rotor in the height direction, whereby the linear height actuator (6A, 6B) comprises a static linear component (6A) attached to the stator and a mobile linear component (6B) attached to the rotor and configured to interact with the static linear component to induce an axial movement of the rotor with respect to the stator, whereby the device comprises an RT position measurement component (9) configured for obtaining an angular position of the rotor with respect to the stator and a Z position measurement component (10) configured for obtaining a height position of the rotor with respect to the stator, whereby the device comprises a processor configured for: - receiving a measured height value of the height position obtained by the Z position measurement component; - compare the measured height value with a predefined target height value, and - steer the linear height actuator to compensate for differences between the measured height value and the target height value, thereby steering the height position of the rotor.

## Description

### Technical field

The present invention pertains to the field of positioning devices and methods for surface irregularities, in particular for inspection of wafers and chips, such as semiconductor wafers.

### Background

Semiconductor wafers are typically very thin circularly shaped objects which are meant to be provided with structures such as chips, transistors, logical gates, etc. In many applications, it is necessary to inspect the surface of such wafers and/or of the structures provided thereon or therein for defects.

Wafer inspection, which has flown well under the radar for most of the semiconductor industry, is becoming more critical amid the need to find defects earlier in the manufacturing process flow. Finding those defects is getting harder as critical dimensions shrink. It's more difficult to actually detect smaller defects on bare wafers, there is more data to process, and there is more pressure to process and inspect more quickly. And while there are solutions to all of these problems, there is a cost associated with each of them. Generally, wafer inspection is split into two categories-unpatterned and patterned. In simple terms, unpatterned wafer inspection looks for defects on unprocessed or bare silicon wafers. The present invention is particularly concerned with unpatterned wafer inspection, but may also be used in patterned wafer inspection.

One way of inspecting wafers, patterned and unpatterned, is to shine light, preferably laser light, onto the wafer surface, and observe the resulting reflected light. Deviations from the expected properties of the reflected light, e.g. concerning angle, amplitude, diffraction, interference, etc. then provide information on defects in the wafer surface. In order to allow such optical inspection, the wafer needs to be positioned very precisely to make sure that deviations are due to surface defects and not to inaccuracies in the positioning system of the wafer. This is particularly important in the case the light beam and/or the light detector have a small focal zone, i.e. the light beam is focused to a predefined distance to within a small error and/or the light detector is likewise focused to such predefined distance to within a small error. Rather than changing the focal zone of the light beam and/or light detector, it may be preferred to alter the position of the surface under inspection.

A goal of the present invention is to provide an accurate positioning device allowing to accurately position a wafer or chip. A preferred application of the present invention is to find defects on wafers or chips at high throughputs with reasonable costs.

Patent document US 6,700,249 B1 discloses a direct drive vertical lift and rotation stage which comprises an annular z-axis housing having a central opening, a z-axis rotor assembly journaled within the central opening of the z-axis housing, a motor between the z-axis housing and the z-axis rotor, an annular theta-axis housing having a central opening, a theta-axis rotor assembly journaled within the central opening of the theta-axis housing, and a motor between the theta-axis housing and the theta-axis rotor.

Patent document US 10,481,102 B2 discloses a multi-axis positioning system that may be used in conjunction with an inspection system and which includes multiple position sensors corresponding to multiple axes in conjunction with multiple motors also corresponding to multiple axes to provide high accuracy, high load and extended travel for controllable movement of an object in up to 6 degrees of freedom. Some embodiments of the multi-axis positioning system may include an x-y stage assembly, a bottom plate assembly coupled to the x-y stage assembly, a top plate assembly coupled to the bottom plate assembly, and a chuck secured to the top plate assembly with multiple position sensors configured to measure displacement between the x-y stage assembly and top plate assembly.

The present invention aims to improve on the prior art systems and methods by providing a positioning device which allows accurate wafer inspection at high rotation speeds up to 100 Hz (6000 rpm). Note hereby that the wafer may preferably be rotated continuously a large number of periods, i.e. the rotation of the wafer is not necessarily limited to 360° or less. However, the present invention can also be used for processes wherein the rotation axis is stationary during e.g. a production or metrology process applied to a substrate; e.g. the wafer, a die or a chip. In those applications, the positioning device can be used to reposition the substrate in between e.g. production or metrology process steps.

### Summary of the invention

The present invention concerns a positioning device as described in claim 1, a positioning method as described in claim 13 and a wafer inspection method as described in claim 15. Further embodiments of the invention are described in the other claims and in the present description.

Ideally, wafer inspection, and in particular unpatterned wafer inspection, is performed by rotating the wafer around its axis at a frequency which is as high as possible to decrease processing times. As discussed above, one way of inspecting wafers, patterned and unpatterned, is to shine light, preferably laser light, onto the wafer surface, and observe the resulting reflected light. Deviations from the expected properties of the reflected light, e.g. concerning angle, amplitude, diffraction, interference, etc. then provide information on defects in the wafer surface. the rotation of the wafer can be combined with a radial movement of the laser beam, i.e. a movement of the laser beam from and/or to the wafer axis. The combination of rotational and radial movement allows to scan essentially the full surface of the wafer.

If, however, the rotational axis of the positioning device is not exactly parallel to the wafer axis, i.e. if the wafer is tilted, it will wobble at a frequency essentially the same as the frequency of the positioning device. This wobble needs to be compensated by high-speed adaptation of the height of the wafer, the height hereby referring to the position along the rotary axis. Also other deviations from in-plane positioning of the wafer can be compensated for, for instance:
- wafers having a saddle shape;
- wafers having intended differences in thickness at different positions;
- etc.

The present invention is capable of changing the height of the rotor very quickly due to the bearing between rotor and stator which allows both a rotational movement and an axial movement of the rotor with respect to the stator, in combination with the decoupling of the rotary actuator and the linear actuator, whereby both actuators are configured to induce the respective movements of the rotor with respect to the stator. Note that prior art techniques which decouple the movements, typically involve a first stage with a first moving component onto a static component and a second stage with a second moving component onto the first moving component. Clearly, this is in contrast with the present invention wherein the linear actuator and the rotary actuator each have a static component attached to the stator which interacts with a mobile component attached to the rotor which interact to induce the respective movements of the rotor with respect to the stator.

### Overview of the figures

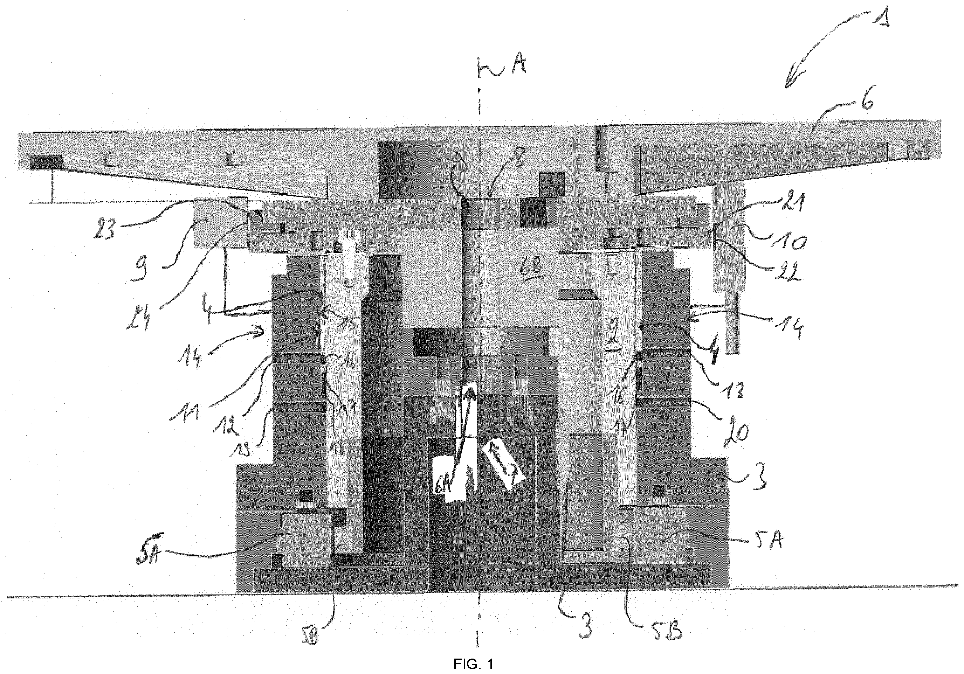

**Figure 1** illustrates a positioning device according to the present invention.
**Figure 2** illustrates a method for inspecting a wafer in accordance with the present invention.

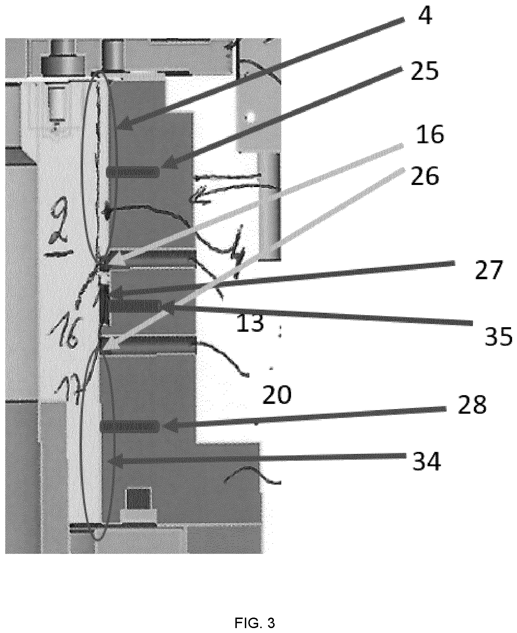

**Figure 3** illustrates a close up of an embodiment of a positioning device comprising an air bearing according to the present invention.

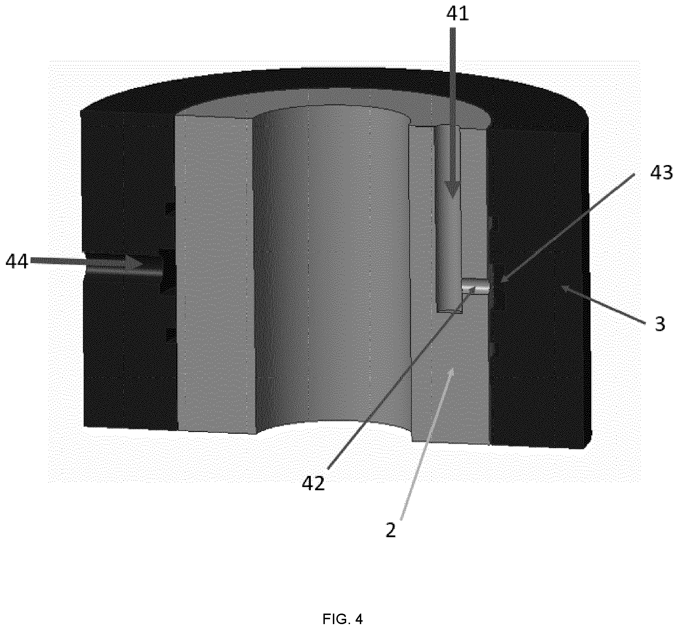

**Figure 4** illustrates an embodiment according to the present invention with a rotor table duct provided in the rotor.

### Detailed description of the invention

The present invention is now further discussed with reference to the figures.

As indicated above, the present invention concerns a positioning device (1) for inspection of wafers and chips, comprising a rotor (2) and a stator (3), the rotor comprising a rotor axis (A) defining a height direction, whereby the rotor (2) is engaged with the stator by a bearing (4) which is configured to allow rotational movement of the rotor (2) around the rotor axis and axial movement along the rotor axis. Preferably the bearing is an air bearing such as an air bearing bushing. In other embodiments, the bearing is or comprises a ball bearing, preferably a ball bushing. Note that air bearings tend to be preferred as they:
- lead to low friction which leads to a more stable rotational speed and creates less heat,
- are less error prone, and
- do not require lubrication, leading to a cleaner environment, which is much preferred in cases where the present device is used in a clean room environment.

The device (1) comprises a rotary (RT) actuator (5A, 5B) configured to induce a rotational movement on the rotor. The rotation is preferably continuous and may continue essentially indefinitely, i.e. preferably the rotational movement is not limited to a specific angular range or to a finite number of full rotations.

The rotary actuator (5A, 5B) comprises a static actuator component (5A) attached to the stator, and a mobile actuator component (5B) attached to the rotor and configured to interact with the static actuator component to induce a rotational movement of the rotor with respect to the stator. Preferably, the rotary actuator (5A, 5B) is an electromechanical actuator comprising the static actuator component (5A) and the mobile actuator component (5B). Hereby, preferably, the static actuator component and the mobile actuator component comprising a magnet, an electromagnet, an electromagnetic coil, a permanent magnet, a magnetic material or any combination thereof. More preferably, the static actuator component comprises an electromagnetic coil and the mobile actuator component comprises a permanent magnet or an electromagnet, whereby the electromagnetic coil of the static actuator component is configured to induce a magnetic field at the position of the permanent magnet or electromagnet of the mobile actuator component in such a way as to generate a torque on the rotor.

The device (1) comprises a linear height actuator (6A, 6B) provided along the rotor axis and configured to induce a linear movement on the rotor in the height direction. The linear height actuator (6A, 6B) comprises a static linear component (6A) attached to the stator and a mobile linear component (6B) attached to the rotor and configured to interact with the static linear component to induce an axial movement of the rotor with respect to the stator. In some embodiments, the device comprises 1 linear height actuator, in other embodiments, the device comprises multiple linear height actuators, such as 2, 3, 4, 5, 6, 7, 8, 9, 10 or more. Preferably, the static linear component and the mobile linear component comprises a magnet, an electromagnet, an electromagnetic coil, a permanent magnet, a magnetic material or any combination thereof. More preferably, the static linear component comprises an electromagnetic coil essentially around the rotor axis and preferably at least partially inserted into a cavity of the mobile linear component, and the mobile linear component comprises a permanent magnet or an electromagnet. More preferably the linear height actuator is or comprises a voice coil actuator.

In preferred embodiments, the rotary actuator and the linear height actuator are separated. In other preferred embodiments, the rotary actuator and the linear actuator are combined into a single 2D actuator configured to actuate a combined rotational and axial movement. Hereby, the static actuator component and the static linear component may preferably also be combined in a static 2D actuator component attached to the stator, and/or the mobile actuator component and the mobile linear actuator component may preferably be combined in a mobile 2D actuator component attached to the rotor.

The device comprises an RT position measurement component (9) configured for obtaining an angular position of the rotor with respect to the stator and a Z position measurement component (10) configured for obtaining a height position of the rotor with respect to the stator. Preferably, the RT position measurement component is an RT encoder and/or the Z position measurement component is a Z encoder. In some embodiments, the RT encoder and the Z encoder are combined into a 2D encoder. In other embodiments, the RT encoder and the Z encoder are essentially provided separately.

The RT position measurement component, preferably the RT encoder, and the Z position measurement component, preferably the Z encoder, may serve multiple roles. The encoders are configured to obtain positional information of the rotor with respect to the stator, the positional information containing both the angle of rotation and the height of the rotor. The positional information can be used to steer the rotor, e.g. to adjust the rotor's height using the linear height actuator or to decrease or increase the rotor's angular velocity using the rotary actuator in correspondence with a preset trajectory. As such, some phenomena such as tilt, saddle-shape, thickness variations, can be quickly and accurately compensated for, even at high rotation speeds such as up to 100 Hz. This can be achieved by the bandwidth of the movement in the height direction being also up to about 100 Hz, in particular due to the decoupling of the rotational and axial movements and because the actuators are both supported on the stator, i.e. the mass of the rotor can be kept small, thereby allowing fast movement. Furthermore, the positional information can be required in the case of wafer inspection to identify the location of any irregularities. For instance, the positional information can be combined with observations made by an inspection method which indicate an irregularity. This combination can then be used to look in more detail to the position of the irregularity in further inspections. As such, this can help to optimize wafer production processes.

In an embodiment, the Z position measurement component is a Z encoder, which preferably comprises a set of circumferential graduation markings (21) provided in the height direction on a circumferential surface of the rotor and a Z sensor (22) configured for reading a height position of the circumferential graduation markings, the Z sensor attached to the stator. The set of circumferential graduation markings may comprise grooves and/or printed lines on the circumferential surface. Typically, the set of circumferential graduation markings comprise grooves around the circumferential surface of the rotor, the grooves preferably being equidistantly spaced along the height direction. As such, they form a diffraction grating. In this embodiment, preferably the Z sensor comprises a light beam, preferably an essentially monochromatic light beam such as a LED beam or a laser beam, which is configured to be directed to the circumferential graduation markings and the Z sensor comprises a light detector configured to receive reflected light from the circumferential surface of the rotor and the circumferential graduation markings provided thereon. From the reflected light, the Z sensor, or processing means in functional operation with the Z sensor, may be configured to obtain a value of the height position of the rotor. Note that the Z sensor being attached to the stator indicates that the Z sensor has a fixed position with respect to the stator at least during operation of the device. The attachment hereby may be direct attachment or indirect attachment, i.e. the Z sensor may be mounted onto the stator or the Z sensor may be mounted onto another object, e.g. a laboratory table, onto which the stator is also mounted. In embodiments, the Z encoder is an incremental encoder or an absolute encoder. In an incremental encoder, markings, such as lines, are equidistant and position is typically deduced by counting the number of markings. In an absolute encoder, the position information is encoded in the marking, for instances, the markings can be grooves forming a coded grating.

In embodiments, the Z position measurement component comprises a confocal sensor, a laser interferometer, a capacitive probe, an inductive sensor, an inductive encoder, a laser sensor, a gap measurement sensor configured to measure the gap between a substrate and a stationary reference, or any combination thereof, including a combination comprising the set of circumferential graduation markings and the Z sensor previously discussed. The Z position measurement component hereby can provide height position feedback.

In an embodiment, the RT position measurement component is or comprises an RT encoder which preferably comprises a set of axial graduation markings (23) provided in along a circumferential direction on a circumferential surface of the rotor and a RT sensor (24) configured for reading an angular position of the axial graduation markings (23), the RT sensor attached to the stator. The set of axial graduation markings may comprise grooves and/or printed lines on the circumferential surface. Typically, the set of axial graduation markings comprise grooves around the circumferential surface of the rotor, the grooves preferably being equidistantly spaced along the angular direction. As such, they form a diffraction grating. In this embodiment, preferably the RT sensor comprises a light beam, preferably an essentially monochromatic light beam such as a LED beam or a laser beam, which is configured to be directed to the axial graduation markings and the RT sensor comprises a light detector configured to receive reflected light from the circumferential surface of the rotor and the axial graduation markings provided thereon. From the reflected light, the RT sensor, or processing means in functional operation with the RT sensor, may be configured to obtain a value of the angular position of the rotor. Note that the RT sensor being attached to the stator indicates that the RT sensor has a fixed position with respect to the stator at least during operation of the device. The attachment hereby may be direct attachment or indirect attachment, i.e. the RT sensor may be mounted onto the stator or the RT sensor may be mounted onto another object, e.g. a laboratory table, onto which the stator is also mounted. In embodiments, the RT encoder is an incremental encoder or an absolute encoder. In an incremental encoder, markings, such as lines, are equidistant and position is typically deduced by counting the number of markings. In an absolute encoder, the position information is encoded in the marking, for instances, the markings can be grooves forming a coded grating.

In embodiments, the RT position measurement component comprises a confocal sensor, a laser interferometer, a capacitive probe, an inductive sensor, an inductive encoder, a laser sensor, a gap measurement sensor configured to measure the gap between a substrate and a stationary reference, or any combination thereof, including a combination comprising the set of axial graduation markings and the RT sensor previously discussed. The RT position measurement component hereby can provide angular position feedback.

The device comprises a processor configured for:
∘ receiving a measured height value of the height position obtained by the Z position measurement component, preferably the Z position measurement component comprising or being a Z encoder;
∘ compare the measured height value with a predefined target height value, and
∘ steer the linear height actuator to compensate for differences between the measured height value and the target height value, thereby steering the height position of the rotor.

As such, the height of the rotor can be actively steered. Preferably hereby the processor comprises a PID height controller configured to steer the height of the rotor.

The target height value can be a dynamic input coming from e.g. a gap sensor, measuring the gap between optics and the substrate, e.g. the wafer, the die or the chip.

In an embodiment, the processor is configured for:
∘ receiving a measured angle value of the angular position obtained by the RT position measurement component, preferably whereby the RT position measurement component is or comprises an RT encoder;
∘ compare the measured angle value with a predefined target angle value, and
∘ steer the rotary actuator to compensate for differences between the measured angle value and the target angle value, thereby steering the angular position and/or a rotational speed of the rotor.

As such, the angular position and/or angular velocity of the rotor can be actively steered. Preferably hereby the processor comprises a PID angular controller configured to steer the angular position and/or angular velocity of the rotor.

As indicated above, preferably the bearing is an air bearing. More preferably, the bearing is an air bearing comprising a circumferential slit between an inner surface (15) of the stator and an outer mantle surface (11) of the rotor. Alternatively, the bearing is an air bearing comprising a circumferential slit between an outer mantle surface of the stator and an inner surface of the rotor. Note that the former alternative refers to embodiments wherein the rotor is positioned inside of the stator, and that the latter alternative refers to embodiments wherein the rotor is positioned outside of the stator. It should be noted here that in the embodiments disclosed in the present patent application, the former alternative is discussed, but that any embodiments discussed in terms of the former alternative also refer to embodiments of the latter embodiments, wherein the terms "inner" and "outer" when denoting surfaces of the stator or rotor, are exchanged.

In preferred embodiments, the air bearing comprises one or more primary porous sections, one or more primary orifices and/or one or more primary feedholes (25) provided in the stator and configured to allow pressurized air to be provided to the circumferential slit.

In a preferred embodiment, the air bearing comprises a set of primary radial ducts (12, 13) provided in the stator, each primary radial duct extending from an outer surface (14) of the stator to the inner surface (15) of the stator, preferably configured for allowing fluid, preferably air, to escape from the circumferential slit to the outside atmosphere. These primary radial ducts allow to decouple the circumferential slit of the air bearing, and the pressurized fluid therein, from other optional features in the present invention, such as the circumferential ring and/or the presence of a table duct.

In a preferred embodiment, the air bearing comprises one or more circumferential grooves (16) provided in the outer mantle surface (15) of the rotor or the inner mantle of the stator, the groove being configured to receive pressurized fluid from the circumferential slit and/or circumferential ring and allow the pressurized air to evacuate to the atmosphere, e.g. via the primary radial ducts, thereby stabilizing the rotor during rotation, e.g. by blocking unwanted radial and tilt motion of the rotor during changes in the pressure of the pressurized fluid provided to e.g. the air bearing or the circumferential ring.

In a preferred embodiment, the device comprises a circumferential rim (17) provided in the outer mantle surface (15) of the rotor, and a corresponding circumferential rim (18) provided in the inner surface (15) of the stator, whereby a circumferential ring (27) is defined by:
∘ the outer mantle surface of the rotor (15),
∘ the circumferential rim (17) provided in the outer mantle surface (15) of the rotor,
∘ the inner surface (15) of the stator, and
∘ circumferential rim (18) provided in the inner surface (15) of the stator.

Hereby, the device preferably comprises one or more secondary porous sections, one or more secondary orifices and/or one or more secondary feedholes (35) provided in the stator and configured to allow pressurized air to be provided to the circumferential ring (27).

The device preferably further comprises a set of secondary radial ducts (19, 20) provided in the stator, each secondary radial duct extending from an outer surface (14) of the stator to the inner surface (15) of the stator at an opposite side of the circumferential ring (27) compared to the primary radial ducts, preferably configured for allowing fluid, preferably air, to escape from a circumferential slit and/or circumferential ring to the outside . Preferably the device is configured to provide pressurized fluid to the circumferential ring at a pressure selected to compensate for a mass of the rotor and/or a substrate fixated onto the rotor.

The circumferential ring can serve as a mass compensator and/or for providing an axial force to the rotor. The pressure of the fluid provided to the one or more secondary porous sections, one or more primary orifices and/or one or more primary feedholes (35) allow to arrange the height of the rotor or the axial force applied thereon. This is a low-speed and accurate adaptation mechanism and can mainly be used to compensate for different substrates being tested, which different substrates can have different masses or to press substrates against another surface. Furthermore, the fluid pressure may also be used to arrange an average height of the rotor with respect to the stator during the rotational movement of the rotor. This is particularly useful for ensuring that the Z position measurement component, preferably being or comprising a Z encoder or a gap measurement sensor, can accurately and correctly measure the height position of the rotor. For instance, if a gap measurement sensor is used, i.e. a sensor which measures a gap in the axial direction between the substrate and an external reference, such sensor can have a high resolution, higher than e.g. a Z encoder, but may only have such resolution within a small gap measuring range. The fluid pressure of the fluid provided to the circumferential ring may be controlled to ensure that the substrate is axially displaced, e.g. lifted or lowered, to within said gap measurement range.

In embodiments, the device comprises multiple air bearings. For instance, the device comprises a second air bearing comprising a second circumferential slit (34) between stator and rotor, optionally provided with one or more porous sections, one or more orifices and/or one or more feedholes (28) provided in the stator and configured to allow pressurized air to be provided to the second circumferential slit (34). In case of more air bearings, each air bearing preferably comprises a circumferential slit between stator and rotor, optionally provided with one or more porous sections, one or more orifices and/or one or more feedholes provided in the stator and configured to allow pressurized air to be provided to the circumferential slit. Preferably, in case of multiple air bearings, such as 2, 3, 4, 5, 6, 7, 8, 9, 10 or more air bearings, radial ducts are provided in between axially neighbouring air bearings and/or an axially neighbouring circumferential ring, for evacuating pressurized air from said neighbouring circumferential slits and/or circumferential ring. Note that this allows a modular construction of the device, in particular in cases when a larger device is desired at least in the axial direction.

In a preferred embodiment, the rotor comprises a table (6), preferably comprising a chuck. A chuck is a plate on which wafers can be securely mounted during wafer processing applications. In many cases, chucks have circular vacuum grooves or patterns comprised of micro-holes that enable them to fasten the wafers in place. Lift pins fitted into the chuck assembly allow the plates to automatically raise and lower the wafers throughout the wafer manufacturing and testing process.

In an embodiment, the linear height actuator comprises a table duct essentially along the height direction extending from the stator into the rotor and a rotary union configured to seal the table duct in such a way as to permit a fluid to flow between the rotor and the stator without leakage. This is particularly preferred if the rotor comprises a chuck. Hereby, the vacuum can be provided to the chuck via said table duct.

Preferably the table duct comprises a stator inlet (7) located in the stator and a rotor inlet (8) located in the rotor. The table duct allows to provide at least a partial vacuum to the table. In a preferred embodiment, the device comprises a rotary union (9) at the stator inlet (7) and/or at the rotor inlet (8), the rotary union configured to seal the table duct in such a way as to permit a fluid to flow between the rotor and the stator without leakage. Hereto, the rotary union can be attached with a static rotary union component to the stator and can be attached with a mobile rotary union component to the rotor. This is particularly useful if the table comprises a wafer chuck relying on internal under pressure to fixate a wafer on top of the chuck. In a very preferred embodiment, the linear height actuator is essentially hollow.

Alternatively, or additionally, the rotor comprises one or more rotor table ducts comprising an axial portion (41) extending from an axial end of the rotor, where a table is or can be mounted, into a portion of the rotor (2), and the one or more rotor table ducts comprising a radial portion (42) fluidly connecting the axial portion (41) to a circumferential groove (43) provided in an outer mantle surface the rotor (2) and/or in an inner mantle surface of the stator (3), whereby the stator (3) comprises one or more stator table ducts (44) fluidly connected to said circumferential groove. The stator table ducts (44) can be connected to e.g. a pump for providing pressurized fluid or a vacuum to components of the rotor. As such, a vacuum can be provided via the stator table ducts, the circumferential groove and the rotor table ducts to e.g. a chuck.

The present invention also concerns a positioning method for positioning a substantially flat substrate, preferably a wafer, a die or a chip, comprising the steps of:
∘ providing a rotor and a stator, whereby the rotor is engaged with the stator by a bearing which is configured to allow rotational movement of the rotor (2) around a rotor axis and axial movement along the rotor axis;
∘ fixating the substrate on a rotor;
∘ rotating the rotor with the substrate around a rotor axis, whereby the rotor is rotated with respect to the stator;
∘ obtaining an angular position of the rotor with respect to a stator and obtaining a height position of the rotor with respect to the stator;
∘ compare a measured height value of the height position with a predefined target height value, and
∘ steer a linear height actuator to compensate for differences between the measured height value and the target height value, thereby steering the height position of the rotor with respect to the stator.

The positioning method is preferably executed using a positioning device according to the present invention.

In an embodiment, the method comprises the step of providing a target height value, preferably by an external sensor and/or an external processor.

The present invention also concerns a wafer inspection method comprising executing the positioning method according to the present invention, wherein the substrate is a wafer, the wafer inspection method further comprising the steps of:
∘ directing focused laser light onto the wafer while it is rotating;
∘ measuring reflected laser light from a surface of the wafer, and
∘ comparing the measured reflected laser light to a predefined expected reflection pattern, whereby deviations from said pattern signal irregularities on the wafer surface.

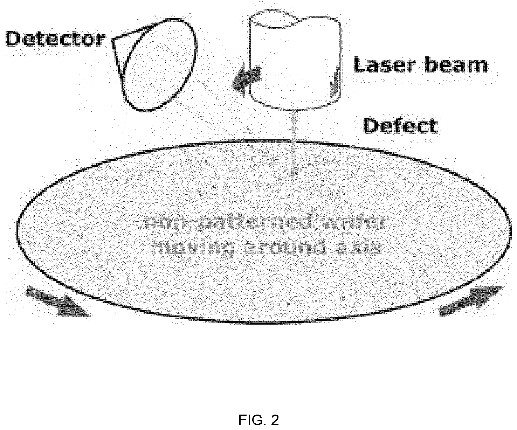

The wafer inspection method is illustrated in Fig. 2.

## Claims

1. A positioning device (1) for inspection of wafers and chips, comprising a rotor (2) and a stator (3), the rotor comprising a rotor axis (A) defining a height direction, whereby the rotor (2) is engaged with the stator by a bearing (4) which is configured to allow rotational movement of the rotor (2) around the rotor axis and axial movement along the rotor axis,
whereby the device (1) comprises a rotary (RT) actuator (5A, 5B) configured to induce a rotational movement on the rotor,
whereby the rotary actuator (5A, 5B)) comprises a static actuator component (5A) attached to the stator, and a mobile actuator component (5B) attached to the rotor and configured to interact with the static actuator component to induce a rotational movement of the rotor with respect to the stator,
whereby the device (1) comprises a linear height actuator (6A, 6B) provided along the rotor axis and configured to induce a linear movement on the rotor in the height direction, whereby the linear height actuator (6A, 6B) comprises a static linear component (6A) attached to the stator and a mobile linear component (6B) attached to the rotor and configured to interact with the static linear component to induce an axial movement of the rotor with respect to the stator,
whereby the device comprises an RT position measurement component (9) configured for obtaining an angular position of the rotor with respect to the stator and a Z position measurement component (10) configured for obtaining a height position of the rotor with respect to the stator,
whereby the device comprises a processor configured for:
∘ receiving a measured height value of the height position obtained by the Z position measurement component;
∘ compare the measured height value with a predefined target height value, and
∘ steer the linear height actuator to compensate for differences between the measured height value and the target height value, thereby steering the height position of the rotor.

2. A positioning device according to claim 1, whereby the bearing is an air bearing comprising a circumferential slit between an inner surface (15) of the stator and an outer mantle surface (11) of the rotor.

3. A positioning device according to claim 2, whereby the air bearing comprises one or more primary porous sections, one or more primary orifices and/or one or more primary feedholes (25) provided in the stator and configured to allow pressurized air to be provided to the circumferential slit, and/or whereby the air bearing comprises a set of primary radial ducts (12, 13) provided in the stator, each primary radial duct extending from an outer surface (14) of the stator to the inner surface (15) of the stator, preferably configured for allowing fluid, preferably air, to escape from the circumferential slit to the outside atmosphere.

4. A positioning device according to any of claim 2 or 3, whereby the air bearing comprises one or more circumferential grooves (16) provided in the outer mantle surface (15) of the rotor or the inner mantle of the stator, the groove being configured to receive pressurized fluid from a circumferential slit and/or a circumferential ring and allow the pressurized air to evacuate to the atmosphere, preferably via the primary radial ducts.

5. A positioning device according to any of the claims 2 to 4, whereby the device comprises a circumferential rim (17) provided in the outer mantle surface (15) of the rotor, and a corresponding circumferential rim (18) provided in the inner surface (15) of the stator, whereby a circumferential ring is defined by:
∘ the outer mantle surface of the rotor (15),
∘ the circumferential rim (17) provided in the outer mantle surface (15) of the rotor,
∘ the inner surface (15) of the stator, and
∘ circumferential rim (18) provided in the inner surface (15) of the stator,
whereby the device comprises one or more secondary porous sections, one or more secondary orifices and/or one or more secondary feedholes (35) provided in the stator and configured to allow pressurized fluid, preferably air, to be provided to the circumferential ring (27).

6. A positioning device according to any of the previous claims, whereby the processor is configured for:
∘ receiving a measured angle value of the angular position obtained by the RT position measurement component, preferably whereby the RT position measurement component is or comprises an RT encoder;
∘ compare the measured angle value with a predefined target angle value, and
∘ steer the rotary actuator to compensate for differences between the measured angle value and the target angle value, thereby steering the angular position and/or a rotational speed of the rotor.

7. A positioning device according to any of the previous claims, whereby the rotary actuator (5A, 5B)) is an electromechanical actuator comprising the static actuator component (5A) and the mobile actuator component (5B), preferably the static actuator component and the mobile actuator component comprising a magnet, an electromagnet, an electromagnetic coil, a permanent magnet, a magnetic material or any combination thereof.

8. A positioning device according to any of the previous claims, whereby the rotor comprises a table (6), preferably comprising a chuck.

9. A positioning device according to any of the previous claims, whereby the static linear component and the mobile linear component comprises a magnet, an electromagnet, an electromagnetic coil, a permanent magnet, a magnetic material or any combination thereof, more preferably whereby the linear height actuator is or comprises a voice coil actuator.

10. A positioning device according to any of the previous claims, whereby the linear height actuator comprises a table duct essentially along the height direction extending from the stator into the rotor and a rotary union configured to seal the table duct in such a way as to permit a fluid to flow between the rotor and the stator without leakage or whereby the rotor comprises one or more rotor table ducts comprising an axial portion (41) extending from an axial end of the rotor into a portion of the rotor (2) at the level of the circumferential slit of the air bearing, and the one or more rotor table ducts comprising a radial portion (42) fluidly connecting the axial portion (41) to a circumferential groove (43) provided in an outer mantle surface the rotor (2) and/or in an inner mantle surface of the stator (3), whereby the stator (3) comprises one or more stator table ducts (44) fluidly connected to said circumferential groove.

11. A positioning device according to any of the previous claims, whereby the Z position measurement component is a Z encoder which preferably comprises a set of circumferential graduation markings (21) provided in the height direction on a circumferential surface of the rotor and a Z sensor (22) configured for reading a height position of the circumferential graduation markings, the Z sensor attached to the stator.

12. A positioning device according to any of the previous claims, whereby the RT position measurement component is an RT encoder which preferably comprises a set of axial graduation markings (23) provided in along a circumferential direction on a circumferential surface of the rotor and a RT sensor (24) configured for reading an angular position of the axial graduation markings (23), the RT sensor attached to the stator.

13. A positioning method for positioning a substantially flat substrate, preferably a wafer or a chip, comprising the steps of:
∘ providing a rotor and a stator, whereby the rotor is engaged with the stator by a bearing which is configured to allow rotational movement of the rotor (2) around a rotor axis and axial movement along the rotor axis;
∘ fixating the substrate on a rotor;
∘ rotating the rotor with the substrate around a rotor axis, whereby the rotor is rotated with respect to the stator;
∘ obtaining an angular position of the rotor with respect to a stator and obtaining a height position of the rotor with respect to the stator;
∘ compare a measured height value of the height position with a predefined target height value, and
∘ steer a linear height actuator to compensate for differences between the measured height value and the target height value, thereby steering the height position of the rotor with respect to the stator.

14. A positioning method according to claim 13, executed using a positioning device according to any of the claims 1 to 12.

15. A wafer inspection method comprising executing the method of any of the claims 13 or 14 wherein the substrate is a wafer, the wafer inspection method further comprising the steps of:
∘ directing focused laser light onto the wafer while it is rotating;
∘ measuring reflected laser light from a surface of the wafer, and
∘ comparing the measured reflected laser light to a predefined expected reflection pattern, whereby deviations from said pattern signal irregularities on the wafer surface.
